(19) Europäisches Patentamt
European Patent Office
Office européen des brevets

(11) **EP 4 368 950 A1**

(12) **EUROPEAN PATENT APPLICATION**

(43) Date of publication:
**15.05.2024   Bulletin 2024/20**

(21) Application number: **23207929.3**

(22) Date of filing: **06.11.2023**

(51) International Patent Classification (IPC):
***G01D 5/14*** *(2006.01)*        ***F15B 15/28*** *(2006.01)*

(52) Cooperative Patent Classification (CPC):
**G01D 5/145; F15B 15/28;** G01D 2205/18

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **11.11.2022   JP 2022180693**

(71) Applicant: **SMC Corporation
Tokyo 101-0021 (JP)**

(72) Inventor: **YAMAGISHI, Takeshi
Ibaraki, 300-2493 (JP)**

(74) Representative: **Keil & Schaafhausen
Patentanwälte PartGmbB
Bockenheimer Landstraße 25
60325 Frankfurt am Main (DE)**

(54) **POSITION CALCULATION DEVICE**

(57)    A position calculation device (10) calculates a position of a magnet (38) installed on a moving body that is capable of moving relatively in a first direction. The position calculation device includes a first magnetic sensor (52) and a second magnetic sensor (54) arranged apart from each other by a predetermined distance (P) in the first direction, and a calculation circuit that calculates the position of the magnet, using a first ratio (R1) between a first component in the first direction and a second component in a second direction, of a first magnetic flux density (B1) detected by the first magnetic sensor, a second ratio (R2) between a third component in the first direction and a fourth component in the second direction, of a second magnetic flux density (B2) detected by the second magnetic sensor, and the predetermined distance.

FIG. 1

EP 4 368 950 A1

**Description**

BACKGROUND OF THE INVENTION

FIELD OF THE INVENTION

The present invention relates to a position calculation device.

DESCRIPTION OF THE RELATED ART

In JP 2019-049528 A, a sensor is disclosed that uses two sensor elements in order to generate a position signal of a magnet. The magnet is fixed to a piston of a pneumatic cylinder. Therefore, the magnet undergoes linear relative motion. ARCTAN values of two mutually perpendicular components of a magnetic field detected by the sensor elements are used, and thereby the position signal of the magnet is generated.

SUMMARY OF THE INVENTION

In order to calculate the position of the magnet from the ARCTAN values as disclosed in JP 2019-049528 A, information of the distance between the sensor elements and a straight line along which the relative movement of the magnet takes place is required. However, the position where the magnet is installed may differ depending on the type of the product or each of individual ones of the products. Accordingly, a problem arises in that a conversion table for converting the ARCTAN values to the position of the magnet is required for each of respective product types or individual ones of the products.
The present invention has the object of solving the aforementioned problem.
One aspect of the present invention is characterized by a position calculation device configured to calculate a position of a magnet installed on a moving body that is configured to move relatively in a first direction with respect to a fixed member, the position calculation device including a first magnetic sensor and a second magnetic sensor installed on the fixed member, and arranged apart from each other by a predetermined distance in the first direction, and configured to detect a magnetic flux density of a magnetic field generated by the magnet, and a calculation circuit configured to calculate the position of the magnet, using a first ratio between a first component in the first direction and a second component in a second direction perpendicular to the first direction, of a first magnetic flux density detected by the first magnetic sensor, a second ratio between a third component in the first direction and a fourth component in the second direction, of a second magnetic flux density detected by the second magnetic sensor, and the predetermined distance.
According to the present invention, it is possible to accurately calculate the position of the magnet.
The above and other objects, features, and advantages of the present invention will become more apparent from the following description when taken in conjunction with the accompanying drawings, in which a preferred embodiment of the present invention is shown by way of illustrative example.

BRIEF DESCRIPTION OF THE DRAWINGS

FIG. 1 is a diagram illustrating an actuator and a position calculation device according to one embodiment;
FIG. 2 is a diagram for the purpose of describing a state in which the position calculation device is installed on a cylinder;
FIG. 3 is a diagram schematically showing a magnetic flux density of a magnetic field generated by a magnet;
FIG. 4 is a diagram for the purpose of describing calculation of the position of the magnet;
FIG. 5 is a graph showing the result of a comparison between actual measured values of the position of the magnet, and calculated values calculated by the position calculation device;
FIG. 6 is a graph showing the result of a comparison between actual measured values of the position of the magnet, and calculated values calculated by the position calculation device;
FIG. 7A is a diagram schematically showing an X component, a Y component, and a Z component of the magnetic flux density at an arbitrary point;
FIG. 7B is a diagram schematically showing a state in which the Y component and the Z component of the magnetic flux density are projected onto an YZ coordinate plane from a positive direction of the X-axis;
FIG. 8 is a diagram for the purpose of describing calculation of the position of the magnet, in a case that a third magnetic sensor is arranged in addition to a first magnetic sensor and a second magnetic sensor; and
FIG. 9 is a diagram showing an example in which a direction in which the two magnetic poles possessed by the magnet are arranged alongside one another does not coincide with the X-axis direction.

DETAILED DESCRIPTION OF THE INVENTION

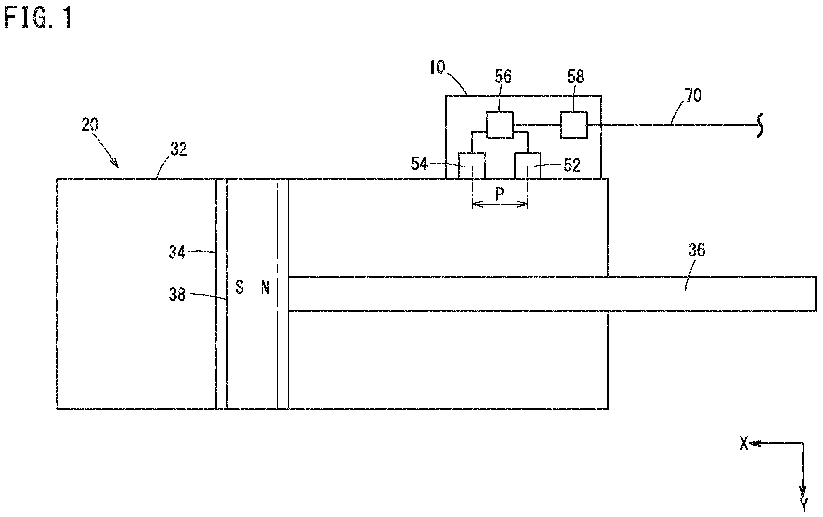

FIG. 1 is a diagram illustrating a position calculation device 10 according to one embodiment and an actuator 20. The actuator 20 includes a fixed member and a moving body. The fixed member of the actuator 20, for example, is a cylinder 32 as shown in FIG. 1. The moving body of the actuator 20, for example, is a piston 34 as shown in FIG. 1. The piston 34 is capable of moving in a first direction relative to the cylinder 32. The first direction defines an X-axis direction. In the example shown in FIG. 1, a second direction perpendicular to the first direction defines a Y-axis direction. A rod 36 is attached to the piston 34. The rod 36 moves relatively in the X-axis direction together with the piston 34.

A magnet 38 is installed on the piston 34. The magnet 38 has two magnetic poles, i.e., a north pole (N pole) and a south pole (S pole). In FIG. 1, an example of the order in which the two magnetic poles of the magnet 38 are arranged is shown. The two magnetic poles of the magnet 38 are arranged alongside one another in order of the N pole and the S pole toward a positive direction of the X-axis direction. When the piston 34 is moved relative to the cylinder 32 in the X-axis direction, the magnet 38 also moves relatively with respect to the cylinder 32 in the X-axis direction.

The position calculation device 10 calculates the position of the magnet 38. The position calculation device 10 includes a first magnetic sensor 52, a second magnetic sensor 54, a calculation circuit 56, and a communication module 58. The first magnetic sensor 52 and the second magnetic sensor 54, for example, are Hall sensors that detect magnetic flux densities based on a voltage generated according to the Hall effect. The first magnetic sensor 52 and the second magnetic sensor 54 may be MR sensors or TMR sensors that detect the magnetic flux density based on an electrical resistance that changes according to a magnetoresistive effect.

The first magnetic sensor 52 and the second magnetic sensor 54, which are mounted on a circuit board, are installed on the cylinder 32. FIG. 1 illustrates an example of the order in which the first magnetic sensor 52 and the second magnetic sensor 54 are arranged alongside one another. The first magnetic sensor 52 and the second magnetic sensor 54 are arranged alongside one another in order of the first magnetic sensor 52 and the second magnetic sensor 54 toward the positive direction of the X-axis direction. The first magnetic sensor 52 and the second magnetic sensor 54 are spaced apart from each other by a predetermined distance P.

The first magnetic sensor 52 detects a first magnetic flux density of the magnetic field generated by the magnet 38 which is moving relatively in the X-axis direction. The second magnetic sensor 54 detects a second magnetic flux density of the magnetic field generated by the magnet 38 which is moving relatively in the X-axis direction. The calculation circuit 56 acquires the first magnetic flux density detected by the first magnetic sensor 52, and the second magnetic flux density detected by the second magnetic sensor 54. The calculation circuit 56 calculates the position of the magnet 38 using the first magnetic flux density, the second magnetic flux density, and the predetermined distance P. The calculation circuit 56 outputs the position of the magnet 38 obtained by calculation to an external device via the communication module 58 and the communication line 70. The communication line 70 may be wired or wireless.

The calculation circuit 56 includes a processor such as a CPU, a GPU, or the like. By the calculation circuit 56 executing a program stored in a non-illustrated storage device, a first magnetic flux density and a second magnetic flux density are acquired, and further, the position of the magnet 38 is calculated. The calculation circuit 56 may be implemented by an integrated circuit such as an ASIC or an FPGA or the like, or alternatively, an electronic circuit including a discrete device.

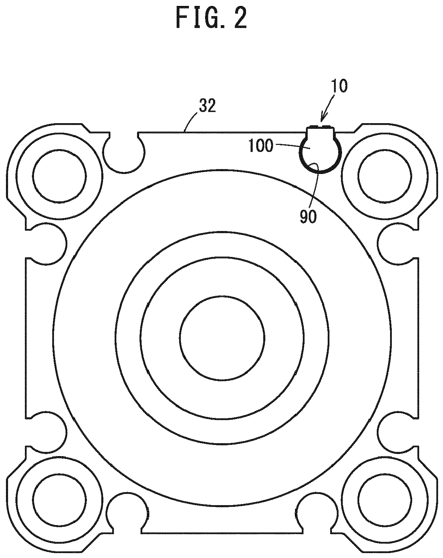

FIG. 2 is a diagram for the purpose of describing a state in which the position calculation device 10 is installed on the cylinder 32. FIG. 2 shows the cylinder 32 and the position calculation device 10 as seen from the X-axis direction in FIG. 1. An attachment groove 90 for the purpose of installing an external device is formed on an outer surface of the cylinder 32. The position calculation device 10 includes an attachment member 100 on a portion of a casing of the position calculation device 10. The position calculation device 10 is fixed to the cylinder 32 by installing the attachment member 100 in the attachment groove 90.

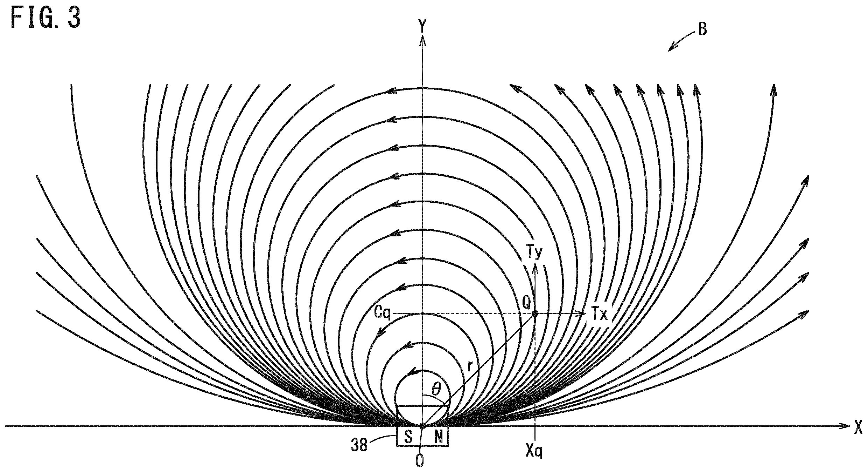

FIG. 3 is a diagram schematically showing a magnetic flux density B of the magnetic field generated by the magnet 38. In FIG. 3, in order to facilitate the description, the direction of a magnetic flux density B is shown on an XY coordinate plane with the position of the magnet 38 being set to an origin point O. The X-axis and the Y-axis are perpendicular to each other. Further, illustration of the magnetic flux density B in the case that $Y < 0$ is omitted. The two magnetic poles of the magnet 38 are arranged alongside one another in order of the S pole and the N pole toward a positive direction of the X-axis direction.

The point Q (Xq, Cq) shown in FIG. 3 has an X coordinate value of Xq, and a Y coordinate value of Cq. A line segment OQ connecting the point Q and the origin O has a length of r. An angle formed between the line segment OQ and the Y-axis is $\theta$. The length r of the line segment OQ is expressed by formula (1) using the X coordinate value Xq and the Y coordinate value Cq of the point Q (Xq, Cq). The angle $\theta$ formed between the line segment OQ and the Y-axis can be calculated by the following formula (2) and formula (3) using the length r of the line segment OQ, and the X coordinate value Xq and the Y coordinate value Cq of the point Q (Xq, Cq).

$$r = \sqrt{Xq^2 + Cq^2} \qquad \ldots(1)$$

$$\sin\ \theta\ =\ Xq/r \qquad \ldots(2)$$

$$\cos\ \theta\ =\ Cq/r \qquad \ldots(3)$$

The magnitude of the magnetic flux density B at the point Q is proportional to the magnitude of the magnetic field generated by the magnet 38 at the point Q. Based on Coulomb's law of magnetic force, the magnitude of the magnetic flux density B at the point Q is expressed by formula (4) using a proportionality constant K, a magnetic quantity m of the magnet 38, and the length r of the line segment OQ described above.

$$B\ =\ Km/r^2 \qquad \ldots(4)$$

With reference to FIG. 3, in the case that the angle $\theta = 0°$, an X component Tx of the magnetic flux density B at the point Q is a minimum value. In the case that the angle $\theta = 0°$, a Y component Ty of the magnetic flux density B at the point Q is zero. In the case that the angle $\theta = 45°$, the X component Tx of the magnetic flux density B at the point Q is zero. In the case that the angle $\theta = 45°$, a Y component Ty of the magnetic flux density B at the point Q is a maximum value. In the case that the angle $\theta = 90°$, the X component Tx of the magnetic flux density B at the point Q is a maximum value. In the case that the angle $\theta = 90°$, the Y component Ty of the magnetic flux density B at the point Q is zero.
Accordingly, it is possible to estimate that the X component Tx of the magnetic flux density B is proportional to $-\cos 2\theta$. It is possible to estimate that the Y component Ty of the magnetic flux density B is proportional to $\sin 2\theta$. More specifically, the X component Tx and the Y component Ty of the magnetic flux density B, which are expressed by formula (4), are expressed, respectively, by formula (5) and formula (6).

$$Tx\ =\ -(Km/r^2)\ \times\ \cos\ 2\theta \qquad \ldots(5)$$

$$Ty\ =\ (Km/r^2)\ \times\ \sin\ 2\theta \qquad \ldots(6)$$

Based on formula (1) to formula (3), formula (5), and formula (6), the X component Tx and the Y component Ty of the magnetic flux density B are expressed, respectively, by formula (7) and formula (8). Accordingly, the ratio R between the X component Tx and the Y component Ty of the magnetic flux density B are expressed as shown in formula (9).

$$Tx = -\frac{Km(Cq^2 - Xq^2)}{(Xq^2 + Cq^2)^2} \qquad \ldots(7)$$

$$Ty = \frac{2KmCqXq}{(Xq^2 + Cq^2)^2} \qquad \ldots(8)$$

$$R = \frac{Tx}{Ty} = -\frac{Cq^2 - Xq^2}{2CqXq} \qquad \ldots(9)$$

When formula (9) is solved for the X coordinate value Xq of the point Q(Xq, Cq), formula (10) is obtained. When formula (9) is solved for the Y coordinate value Cq of the point Q (Xq, Cq), formula (11) is obtained.

$$Xq = Cq \times \left( \frac{Tx}{Ty} \pm \sqrt{\left(\frac{Tx}{Ty}\right)^2 + 1} \right) \qquad \ldots(10)$$

$$Cq = Xq \times \left( -\frac{Tx}{Ty} \pm \sqrt{\left(\frac{Tx}{Ty}\right)^2 + 1} \right) \qquad \dots (11)$$

In both of: the case that the magnetic sensor is positioned at a position (Xq ≥ 0) where the X coordinate value Xq of the position coordinates is a value that is greater than or equal to zero; and the case in which the magnetic sensor is positioned at a position (Xq < 0) where the X coordinate value Xq of the position coordinates is a value less than zero, the Y coordinate value Cq is positive (Cq > 0). As noted previously, the magnet 38 moves relatively in the X-axis direction with respect to the cylinder 32. The first magnetic sensor 52 and the second magnetic sensor 54 are installed on the cylinder 32. The X component Tx and the Y component Ty of the magnetic flux density B, which are detected by each of the first magnetic sensor 52 and the second magnetic sensor 54, change accompanying the relative movement of the magnet 38.

For example, in the case that the first magnetic sensor 52 is positioned at a position (Xq ≥ 0) where the X coordinate value Xq of the position coordinates is greater than or equal to zero, with reference to FIG. 3, the Y component Ty of the magnetic flux density B detected by the first magnetic sensor 52 becomes a value of greater than or equal to zero. In the case that the first magnetic sensor 52 is positioned at a position (Xq < 0) where the X coordinate value Xq of the position coordinates is less than zero, with reference to FIG. 3, the Y component Ty of the magnetic flux density B detected by the first magnetic sensor 52 becomes a value of less than zero.

The relative position of the first magnetic sensor 52 can be calculated in accordance with whether or not the Y component Ty of the magnetic flux density B detected by the first magnetic sensor 52 is greater than or equal to zero, and the order in which the two magnetic poles of the magnet 38 are arranged. Even if the directions of the coordinate axes of the XY coordinate plane shown in FIG. 3 are changed, the relative position of the first magnetic sensor 52 can be calculated in the same manner.

A description will be given concerning a case in which the first magnetic sensor 52 is positioned at a position (Xq ≥ 0) where the X coordinate value Xq of the position coordinates is greater than or equal to zero on the XY coordinate plane where the position of the magnet 38 is set to the origin point O. In consideration of the fact that Xq ≥ 0 and Cq > 0 are satisfied, on the basis of formula (10) and formula (11), the relative position of the first magnetic sensor 52 is expressed as shown in formula (12) and formula (13).

$$Xq = Cq \times \left( \frac{Tx}{Ty} + \sqrt{\left(\frac{Tx}{Ty}\right)^2 + 1} \right) \qquad \dots (12)$$

$$Cq = Xq \times \left( -\frac{Tx}{Ty} + \sqrt{\left(\frac{Tx}{Ty}\right)^2 + 1} \right) \qquad \dots (13)$$

A description will be given concerning a case in which the first magnetic sensor 52 is positioned at a position (Xq < 0) where the X coordinate value Xq of the position coordinates is less than zero on the XY coordinate plane where the position of the magnet 38 is set to the origin point O. In consideration of the fact that Xq < 0 and Cq > 0 are satisfied, on the basis of formula (10) and formula (11), the relative position of the first magnetic sensor 52 is expressed as shown in formula (14) and formula (15).

$$Xq = Cq \times \left( \frac{Tx}{Ty} - \sqrt{\left(\frac{Tx}{Ty}\right)^2 + 1} \right) \qquad \dots (14)$$

$$Cq = Xq \times \left( -\frac{Tx}{Ty} - \sqrt{\left(\frac{Tx}{Ty}\right)^2 + 1} \right) \qquad \dots (15)$$

In FIG. 3, the origin point O of the XY coordinate plane is the position of the magnet 38. In the case that the origin point O of the XY coordinate plane is the position of the first magnetic sensor 52, the relative position of the magnet 38 can also be calculated similarly using the aforementioned formula (12) to formula (15). The same situation applies in the case that the origin point O of the XY coordinate plane is the position of the second magnetic sensor 54.

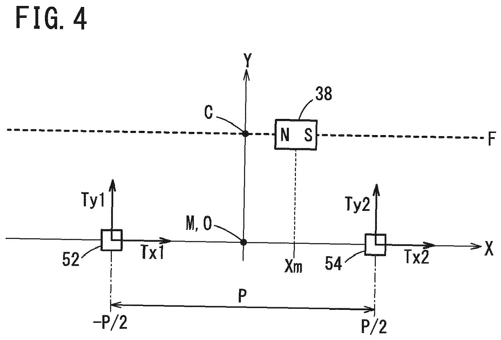

FIG. 4 is a diagram for the purpose of describing calculation of the position of the magnet 38. In FIG. 4, the first magnetic sensor 52 and the second magnetic sensor 54 are positioned on the X-axis while being spaced apart from each other by the predetermined distance P. The origin point O of the XY coordinate plane is the midpoint M between the position of the first magnetic sensor 52 and the position of the second magnetic sensor 54. The X coordinate value of the position of the first magnetic sensor 52 is -P/2, and the Y coordinate value is zero. The X coordinate value of the position of the second magnetic sensor 54 is P/2, and the Y coordinate value is zero in the same manner as the first magnetic sensor 52. The magnet 38 is at a position expressed by the X coordinate value Xm and the Y coordinate value C.

As noted previously, the magnet 38 moves together with the piston 34 relatively with respect to the cylinder 32. A trajectory F of the magnet 38 at that time is as shown in FIG. 4. The trajectory F, which extends in the direction in which the magnet 38 moves, is a straight line in the same direction as the direction in which the first magnetic sensor 52 and the second magnetic sensor 54 are arranged. More specifically, as shown in FIG. 4, the trajectory F of the magnet 38 is parallel to the X-axis on which the first magnetic sensor 52 and the second magnetic sensor 54 are arranged.

The magnetic flux density B detected by the first magnetic sensor 52 is defined as a first magnetic flux density B1. The X component Tx and the Y component Ty of the first magnetic flux density B1 are set, respectively, to an X component Tx1 and a Y component Ty1. The magnetic flux density B detected by the second magnetic sensor 54 is defined as a second magnetic flux density B2. The X component Tx and the Y component Ty of the second magnetic flux density B2 are set, respectively, to an X component Tx2 and a Y component Ty2.

Due to the relative movement of the magnet 38 in the X-axis direction, the X-coordinate value Xm of the position of the magnet 38 changes. Specifically, as shown hereinafter, there are three cases expressed by formulas (16), (17), and (18).

$$-P/2 < Xm < P/2 \qquad \qquad \ldots(16)$$

$$Xm \leq -P/2 \qquad \qquad \ldots(17)$$

$$Xm \geq P/2 \qquad \qquad \ldots(18)$$

In the case expressed by formula (16), the Y component Ty1 of the first magnetic flux density B1 detected by the first magnetic sensor 52 is a value less than zero, and the Y component Ty2 of the second magnetic flux density B2 detected by the second magnetic sensor 54 is a value greater than zero. Accordingly, in this case, formula (19) is satisfied. More specifically, in the case that formula (19) is satisfied, formula (16) regarding the X-coordinate value Xm of the position of the magnet 38 is established. Moreover, even in the case that the two magnetic poles of the magnet 38 are arranged in an opposite order, as a result of the positiveness and negativeness of the Y components Ty1 and Ty2 being reversed, formula (19) is satisfied.

$$Ty1 \times Ty2 < 0 \qquad \qquad \ldots(19)$$

In the case expressed by formula (17), the Y component Ty1 of the first magnetic flux density B1 detected by the first magnetic sensor 52 is a value greater than or equal to zero, and the Y component Ty2 of the second magnetic flux density B2 detected by the second magnetic sensor 54 is a value greater than zero. Further, the magnitude of the first magnetic flux density B1 is greater than the second magnetic flux density B2. Accordingly, in this case, formula (20) and formula (21) are satisfied.

$$Ty1 \times Ty2 \geq 0 \qquad \qquad \ldots(20)$$

$$\sqrt{Tx1^2 + Ty1^2} > \sqrt{Tx2^2 + Ty2^2} \qquad \qquad \ldots(21)$$

In the case expressed by formula (18), the Y component Ty1 of the first magnetic flux density B1 detected by the first magnetic sensor 52 is a value less than zero, and the Y component Ty2 of the second magnetic flux density B2 detected by the second magnetic sensor 54 is a value less than or equal to zero. Further, the magnitude of the first magnetic flux density B1 is less than the second magnetic flux density B2. Accordingly, in this case, formula (20) and formula (22) are satisfied.

$$\sqrt{Tx1^2 + Ty1^2} < \sqrt{Tx2^2 + Ty2^2} \qquad \dots (22)$$

As noted previously, the relative position of the magnet 38 with respect to the first magnetic sensor 52 and the relative position of the magnet 38 with respect to the second magnetic sensor 54 are expressed by the aforementioned formula (12) to formula (15). In the case that the condition expressed by formula (19) is satisfied, based on formula (12) and formula (14), formula (23) and formula (24) are satisfied. In the case that the condition expressed by formula (19) is satisfied, based on formula (23) and formula (24), the values of the coordinates (Xm, C) representing the position of the magnet 38 are expressed by formula (25) and formula (26). Accordingly, in the case that the condition expressed by formula (19) is satisfied, the calculation circuit 56 calculates the position of the magnet 38 by formula (25) and formula (26).

$$Xm = C \times \left( \frac{Tx1}{Ty1} - \sqrt{\left(\frac{Tx1}{Ty1}\right)^2 + 1} \right) + \frac{P}{2} \qquad \dots (23)$$

$$Xm = C \times \left( \frac{Tx2}{Ty2} + \sqrt{\left(\frac{Tx2}{Ty2}\right)^2 + 1} \right) - \frac{P}{2} \qquad \dots (24)$$

$$Xm = P \times \frac{\frac{Tx1}{Ty1} - \sqrt{\left(\frac{Tx1}{Ty1}\right)^2 + 1}}{\frac{Tx2}{Ty2} + \sqrt{\left(\frac{Tx2}{Ty2}\right)^2 + 1} - \left(\frac{Tx1}{Ty1} - \sqrt{\left(\frac{Tx1}{Ty1}\right)^2 + 1}\right)} + \frac{P}{2} \qquad \dots (25)$$

$$C = P \times \frac{1}{\frac{Tx2}{Ty2} + \sqrt{\left(\frac{Tx2}{Ty2}\right)^2 + 1} - \left(\frac{Tx1}{Ty1} - \sqrt{\left(\frac{Tx1}{Ty1}\right)^2 + 1}\right)} \qquad \dots (26)$$

In the case that the condition expressed by formula (20) and the condition expressed by formula (21) are satisfied, based on formula (12) and formula (14), formula (27) and formula (24) are satisfied. In the case that the condition expressed by formula (20) and the condition expressed by formula (21) are satisfied, based on formula (27) and formula (24), the values of the coordinates (Xm, C) representing the position of the magnet 38 are expressed by formula (28) and formula (29). Accordingly, in the case that the condition expressed by formula (20) and the condition expressed by formula (21) are satisfied, the calculation circuit 56 calculates the position of the magnet 38 by formula (28) and formula (29).

$$Xm = C \times \left( \frac{Tx1}{Ty1} + \sqrt{\left(\frac{Tx1}{Ty1}\right)^2 + 1} \right) + \frac{P}{2} \qquad \dots (27)$$

$$Xm = P \times \frac{\frac{Tx1}{Ty1} + \sqrt{\left(\frac{Tx1}{Ty1}\right)^2 + 1}}{\frac{Tx2}{Ty2} + \sqrt{\left(\frac{Tx2}{Ty2}\right)^2 + 1} - \left(\frac{Tx1}{Ty1} + \sqrt{\left(\frac{Tx1}{Ty1}\right)^2 + 1}\right)} + \frac{P}{2} \qquad \dots (28)$$

$$C = P \times \frac{1}{\frac{Tx2}{Ty2} + \sqrt{\left(\frac{Tx2}{Ty2}\right)^2 + 1} - \left(\frac{Tx1}{Ty1} + \sqrt{\left(\frac{Tx1}{Ty1}\right)^2 + 1}\right)} \qquad \ldots (29)$$

In the case that the condition expressed by formula (20) and the condition expressed by formula (22) are satisfied, based on formula (12) and formula (14), formula (23) and formula (30) are satisfied. In the case that the condition expressed by formula (20) and the condition expressed by formula (22) are satisfied, based on formula (23) and formula (30), the values of the coordinates (Xm, C) representing the position of the magnet 38 are expressed by formula (31) and formula (32). Accordingly, in the case that the condition expressed by formula (20) and the condition expressed by formula (22) are satisfied, the calculation circuit 56 calculates the position of the magnet 38 by formula (31) and formula (32).

$$Xm = C \times \left(\frac{Tx2}{Ty2} - \sqrt{\left(\frac{Tx2}{Ty2}\right)^2 + 1}\right) - \frac{P}{2} \qquad \ldots (30)$$

$$Xm = P \times \frac{\frac{Tx1}{Ty1} - \sqrt{\left(\frac{Tx1}{Ty1}\right)^2 + 1}}{\frac{Tx2}{Ty2} - \sqrt{\left(\frac{Tx2}{Ty2}\right)^2 + 1} - \left(\frac{Tx1}{Ty1} - \sqrt{\left(\frac{Tx1}{Ty1}\right)^2 + 1}\right)} + \frac{P}{2} \qquad \ldots (31)$$

$$C = P \times \frac{1}{\frac{Tx2}{Ty2} - \sqrt{\left(\frac{Tx2}{Ty2}\right)^2 + 1} - \left(\frac{Tx1}{Ty1} - \sqrt{\left(\frac{Tx1}{Ty1}\right)^2 + 1}\right)} \qquad \ldots (32)$$

Formula (25), formula (26), formula (28), formula (29), formula (31), and formula (32) can be also expressed by using a first ratio R1 between the X component Tx1 and the Y component Ty1 of the first magnetic flux density B1, and a second ratio R2 between the X component Tx2 and the Y component Ty2 of the second magnetic flux density B2. In that case, formula (33) to formula (38) are obtained. More specifically, the calculation circuit 56 calculates the position of the magnet 38 by using formula (33) to formula (38) in which the first ratio R1, the second ratio R2, and the predetermined distance P are used.

$$Xm = P \times \frac{R1 - \sqrt{R1^2 + 1}}{R2 + \sqrt{R2^2 + 1} - (R1 - \sqrt{R1^2 + 1})} + \frac{P}{2} \qquad \ldots (33)$$

$$C = P \times \frac{1}{R2 + \sqrt{R2^2 + 1} - (R1 - \sqrt{R1^2 + 1})} \qquad \ldots (34)$$

$$Xm = P \times \frac{R1 + \sqrt{R1^2 + 1}}{R2 + \sqrt{R2^2 + 1} - (R1 + \sqrt{R1^2 + 1})} + \frac{P}{2} \qquad \ldots (35)$$

$$C = P \times \frac{1}{R2 + \sqrt{R2^2 + 1} - (R1 + \sqrt{R1^2 + 1})} \qquad \ldots (36)$$

$$Xm = P \times \frac{R1 - \sqrt{R1^2 + 1}}{R2 - \sqrt{R2^2 + 1} - (R1 - \sqrt{R1^2 + 1})} - \frac{P}{2} \qquad \ldots (37)$$

$$C = P \times \frac{1}{R2 - \sqrt{R2^2 + 1} - (R1 - \sqrt{R1^2 + 1})} \qquad \ldots (38)$$

In the case that the product of the Y component Ty1 of the first magnetic flux density B1 and the Y component Ty2 of the second magnetic flux density B2 are less than zero, the condition expressed by formula (19) is satisfied. In the case that the condition expressed by formula (19) is satisfied, the calculation circuit 56 calculates the X coordinate value Xm of the coordinates (Xm, C) representing the position of the magnet 38 by formula (33) using the first ratio R1, the second ratio R2, and the predetermined distance P. The calculation circuit 56 calculates the Y coordinate value C of the coordinates (Xm, C) representing the position of the magnet 38 by formula (34) using the first ratio R1, the second ratio R2, and the predetermined distance P.

In the case that the product of the Y component Ty1 of the first magnetic flux density B1 and the Y component Ty2 of the second magnetic flux density B2 is greater than or equal to zero, and further, the magnitude of the first magnetic flux density B1 is greater than the magnitude of the second magnetic flux density B2, the condition expressed by formula (20) and the condition expressed by formula (21) are satisfied. In the case that the condition expressed by formula (20) and the condition expressed by formula (21) are satisfied, the calculation circuit 56 calculates the X coordinate value Xm of the coordinates (Xm, C) representing the position of the magnet 38 by formula (35) using the first ratio R1, the second ratio R2, and the predetermined distance P. The calculation circuit 56 calculates the Y coordinate value C of the coordinates (Xm, C) representing the position of the magnet 38 by formula (36) using the first ratio R1, the second ratio R2, and the predetermined distance P.

In the case that the product of the Y component Ty1 of the first magnetic flux density B1 and the Y component Ty2 of the second magnetic flux density B2 is greater than or equal to zero, and further, the magnitude of the first magnetic flux density B1 is less than the magnitude of the second magnetic flux density B2, the condition expressed by formula (20) and the condition expressed by formula (22) are satisfied. In the case that the condition expressed by formula (20) and the condition expressed by formula (22) are satisfied, the calculation circuit 56 calculates the X coordinate value Xm of the coordinates (Xm, C) representing the position of the magnet 38 by formula (37) using the first ratio R1, the second ratio R2, and the predetermined distance P. The calculation circuit 56 calculates the Y coordinate value C of the coordinates (Xm, C) representing the position of the magnet 38 by formula (38) using the first ratio R1, the second ratio R2, and the predetermined distance P.

The Y coordinate value C of the position of the magnet 38 varies depending on the dimensions of the piston 34 on which the magnet 38 is installed. Further, an installation error when the magnet 38 is installed on the piston 34 brings about a variation in the Y coordinate value C of the position of the magnet 38. In formula (33), formula (35), and formula (37) in which the first ratio R1, the second ratio R2, and the predetermined distance P are used, instead of the Y coordinate value C of the position of the magnet 38, there is included the predetermined position P. Since the first magnetic sensor 52 and the second magnetic sensor 54 are installed on the cylinder 32 after having been installed on the circuit board, the variation in the predetermined distance P is small.

Accordingly, the X coordinate value Xm of the position of the magnet 38 obtained by formula (33), formula (35), and formula (37) is accurate. Further, the Y coordinate value C of the position of the magnet 38 that brings about the variation is accurately calculated by formula (34), formula (36), and formula (38) in which the predetermined distance P is included.

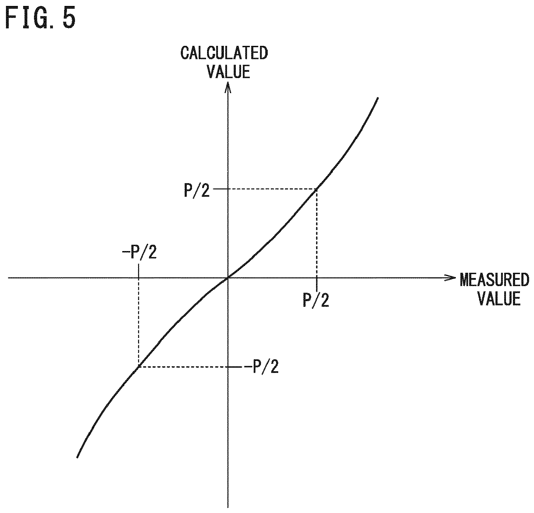

FIG. 5 is a graph showing the result of a comparison between the actual measured values of the position of the magnet 38, and the calculated values calculated by the position calculation device 10. In FIG. 5, the horizontal axis corresponds to the actual measured values, and the vertical axis corresponds to the calculated values. According to FIG. 5, the actual measured values and the calculated values are in general agreement. In particular, in the case that the X-coordinate value Xm of the position of the magnet 38 lies within the range of formula (16), the actual measured values and the calculated values coincide with high accuracy. More specifically, in the case that formula (19) is satisfied, the actual measured values and the calculated values coincide with high accuracy.

[Exemplary Modifications]

The above-described embodiment may be modified in the manner described below.

(Exemplary Modification 1)

In FIG. 5, in the case that the X coordinate value Xm of the position of the magnet 38 lies within the range of formula (17) or the range of formula (18), room exists for more accurate matching between the actual measured values and the calculated values. According to the present modification, the Y coordinate value C of the position of the magnet 38, which is obtained using formula (26) in the case that formula (19) is satisfied, is also used in the case that formula (20) is satisfied. More specifically, by substituting into formula (27) or formula (30) the Y coordinate value C of the position of the magnet 38 obtained in the case that formula (19) is satisfied, the calculation circuit 56 calculates the X coordinate value Xm of the position of the magnet 38 in the case that formula (20) is satisfied.

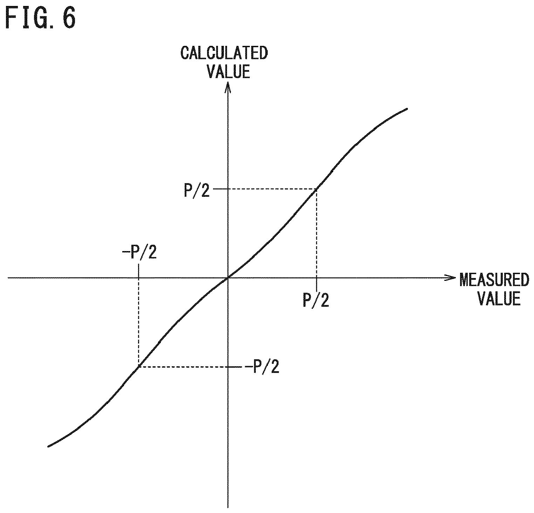

FIG. 6 is a graph showing the result of a comparison between the actual measured values of the position of the magnet 38, and the calculated values calculated by the position calculation device 10. In the case that the X coordinate value Xm of the position of the magnet 38 lies within the range of formula (17) or the range of formula (18), the actual measured values and the calculated values coincide more accurately.

(Exemplary Modification 2)

In FIG. 3, the point Q where each of the first magnetic sensor 52 and the second magnetic sensor 54 detect the magnetic flux density B is arranged on the XY coordinate plane. However, the point Q where the magnetic flux density B is detected need not necessarily be arranged on the XY coordinate plane.

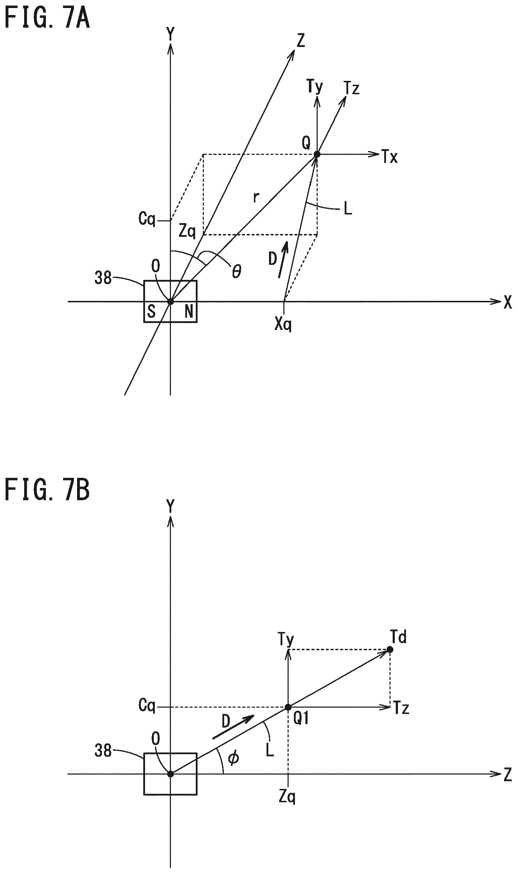

FIG. 7A is a diagram schematically showing the X component Tx, the Y component Ty, and the Z component Tz of the magnetic flux density B at an arbitrary point Q. In FIG. 7A, in order to facilitate the description, the X component Tx, the Y component Ty, and the Z component Tz of the magnetic flux density B are shown on the XYZ coordinate space with the position of the magnet 38 being set at the origin point O. Moreover, in FIG. 7A, a left-handed XYZ coordinate space is shown. The X-axis, the Y-axis, and the Z-axis are perpendicular to each other.

The first direction defines an X-axis direction. In the example shown in FIG. 7A, the second direction perpendicular to the first direction defines a direction D of the line segment L connecting the point where X = Xq on the X axis and the point Q. The second direction is different from both the Y-axis direction and the Z-axis direction. The two magnetic poles of the magnet 38 are arranged alongside one another in order of the S pole and the N pole toward a positive direction of the X-axis direction.

The point Q (Xq, Cq, Zq) shown in FIG. 7A has an X coordinate value of Xq, a Y coordinate value of Cq, and a Z coordinate value of Zq. A line segment OQ connecting the point Q and the origin O has a length of r. An angle formed between the line segment OQ and the Y-axis is θ. In the example shown in FIG. 7A, the X component Tx of the magnetic flux density B is obtained in the same manner as in the example shown in FIG. 3.

FIG. 7B is a diagram schematically showing a state in which the Y component Ty and the Z component Tz of the magnetic flux density B are projected onto an YZ coordinate plane from a positive direction of the X-axis. A point Q1 (0, Cq, Zq) obtained by projecting the point Q (Xq, Cq, Zq) shown in FIG. 7A onto the YZ coordinate plane is shown in FIG. 7B. The direction D of the line segment L and the Z axis form an angle φ.

FIG. 7A and FIG. 7B show a state in which the XY coordinate plane shown in FIG. 3 is rotated about the X-axis until coinciding with a plane parallel to the direction D that forms the angle φ with respect to the Z-axis. The Y component Ty of the magnetic flux density B shown in FIG. 3 corresponds with the component Td shown in FIG. 7B. The component Td is a component of the magnetic flux density B in the direction D. Accordingly, formula (39) and formula (40) are satisfied. Further, according to FIG. 7B, a magnitude |Td| of the component Td is expressed by formula (41). More specifically, the component Td is a synthesized component obtained by synthesizing the Y component Ty and the Z component Tz of the magnetic flux density B shown in FIG. 7B.

$$\sin \phi = Ty/Td \qquad \qquad \dots(39)$$

$$\cos \phi = Tz/Td \qquad \qquad \dots(40)$$

$$|Td| = \sqrt{Ty^2 + Tz^2} \qquad \qquad \dots(41)$$

In formula (12) and formula (13), by giving consideration to formula (39), formula (40), and formula (41), the relative position of the point Q in the XYZ coordinate space with the position of the magnet 38 being set as the origin point O can be obtained. In the case that the first magnetic sensor 52 is positioned at a position where the X coordinate value Xq of the position coordinates is greater than or equal to zero (Xq ≥ 0), the relative position of the first magnetic sensor 52 is expressed as in formula (42), formula (43), and formula (44).

$$Xq = \sqrt{Cq^2 + Zq^2} \times \left( \frac{Ty}{|Ty|} \times \frac{Tx}{\sqrt{Ty^2 + Tz^2}} + \sqrt{\left(\frac{Tx}{\sqrt{Ty^2 + Tz^2}}\right)^2 + 1} \right) \qquad \ldots (42)$$

$$Cq = Xq \times \left( \frac{Ty}{|Ty|} \times \left(-\frac{Tx}{\sqrt{Ty^2 + Tz^2}}\right) + \sqrt{\left(\frac{Tx}{\sqrt{Ty^2 + Tz^2}}\right)^2 + 1} \right) \times \frac{Ty}{\sqrt{Ty^2 + Tz^2}} \qquad \ldots (43)$$

$$Zq = Xq \times \left( \frac{Ty}{|Ty|} \times \left(-\frac{Tx}{\sqrt{Ty^2 + Tz^2}}\right) + \sqrt{\left(\frac{Tx}{\sqrt{Ty^2 + Tz^2}}\right)^2 + 1} \right) \times \frac{Tz}{\sqrt{Ty^2 + Tz^2}} \qquad \ldots (44)$$

In the case that the first magnetic sensor 52 is positioned at a position where the X coordinate value Xq of the position coordinates is less than zero (Xq < 0), the relative position of the first magnetic sensor 52 is expressed as in formula (45), formula (46), and formula (47).

$$Xq = \sqrt{Cq^2 + Zq^2} \times \left( \frac{Ty}{|Ty|} \times \frac{Tx}{\sqrt{Ty^2 + Tz^2}} - \sqrt{\left(\frac{Tx}{\sqrt{Ty^2 + Tz^2}}\right)^2 + 1} \right) \qquad \ldots (45)$$

$$Cq = Xq \times \left( \frac{Ty}{|Ty|} \times \left(-\frac{Tx}{\sqrt{Ty^2 + Tz^2}}\right) - \sqrt{\left(\frac{Tx}{\sqrt{Ty^2 + Tz^2}}\right)^2 + 1} \right) \times \frac{Ty}{\sqrt{Ty^2 + Tz^2}} \qquad \ldots (46)$$

$$Zq = Xq \times \left( \frac{Ty}{|Ty|} \times \left(-\frac{Tx}{\sqrt{Ty^2 + Tz^2}}\right) - \sqrt{\left(\frac{Tx}{\sqrt{Ty^2 + Tz^2}}\right)^2 + 1} \right) \times \frac{Tz}{\sqrt{Ty^2 + Tz^2}} \qquad \ldots (47)$$

In this manner, the relative position of the first magnetic sensor 52 can be calculated. Even if the directions of the coordinate axes of the XYZ coordinate space shown in FIG. 7A and FIG. 7B are changed, the relative position of the first magnetic sensor 52 can be calculated in the same manner.

When a description is given in which the aforementioned FIG. 7A and FIG. 7B are used, the origin point O of the XYZ coordinate space is the position of the magnet 38. In the case that the origin point O of the XYZ coordinate space is the position of the first magnetic sensor 52, the relative position of the magnet 38 can also be calculated similarly using the aforementioned formula (42) to formula (47). The same situation applies in the case that the origin point O of the XYZ coordinate space is the position of the second magnetic sensor 54.

In the same manner as the above-described embodiment, as an arithmetic equation for the X-coordinate value Xm of the position of the magnet 38, it is possible to derive a formula in which the predetermined distance P is included instead of the Y-coordinate value C and the Z-coordinate value Zm of the position of the magnet 38. In the case that the condition expressed by formula (19) is satisfied, the calculation circuit 56 calculates the position (Xm, C, Zm) of the magnet 38 by formula (48), formula (49), and formula (50). In this case, the denominator DIV1 in formula (48), formula (49), and formula (50) is expressed by formula (51). Further, the position (Xm, C, Zm) of the magnet 38 obtained in this manner is a position in the case that the midpoint between the first magnetic sensor 52 and the second magnetic sensor 54 is the origin point O.

$$Xm = P \times \frac{\frac{Ty1}{|Ty1|} \times \frac{Tx1}{\sqrt{Ty1^2+Tz1^2}} - \sqrt{\left(\frac{Tx1}{\sqrt{Ty1^2+Tz1^2}}\right)^2 + 1}}{DIV1} + \frac{P}{2} \qquad \ldots (48)$$

$$C = P \times \frac{1}{DIV1} \times \frac{Ty1}{\sqrt{Ty1^2+Tz1^2}} \qquad \ldots (49)$$

$$Zm = P \times \frac{1}{DIV1} \times \frac{Tz1}{\sqrt{Ty1^2+Tz1^2}} \qquad \ldots (50)$$

$$DIV1 = \frac{Ty2}{|Ty2|} \times \frac{Tx2}{\sqrt{Ty2^2+Tz2^2}} + \sqrt{\left(\frac{Tx2}{\sqrt{Ty2^2+Tz2^2}}\right)^2 + 1} - \left(\frac{Ty1}{|Ty1|} \times \frac{Tx1}{\sqrt{Ty1^2+Tz1^2}} - \sqrt{\left(\frac{Tx1}{\sqrt{Ty1^2+Tz1^2}}\right)^2 + 1}\right) \qquad \ldots (51)$$

The X component Tx1 in the X-axis direction of the first magnetic flux density B1 detected by the first magnetic sensor 52 in the XYZ coordinate space is used in formula (48) to formula (50). The Y-component Ty1 of the first magnetic flux density B1 in the Y-axis direction, and the Z-component Tz1 of the first magnetic flux density B1 in the Z-axis direction are also used in formula (48) to formula (50). The X component Tx2 in the X-axis direction of the second magnetic flux density B2 detected by the second magnetic sensor 54 in the XYZ coordinate space is used in formula (48) to formula (50). The Y-component Ty2 of the second magnetic flux density B2 in the Y-axis direction, and the Z-component Tz2 of the second magnetic flux density B2 in the Z-axis direction are also used in formula (48) to formula (50). Furthermore, the predetermined distance P between the first magnetic sensor 52 and the second magnetic sensor 54 is used in formula (48) to formula (50).

In the case expressed by formula (17), the Y component Ty1 of the first magnetic flux density B1 detected by the first magnetic sensor 52 is a value greater than or equal to zero, and the Y component Ty2 of the second magnetic flux density B2 detected by the second magnetic sensor 54 is a value greater than zero. Further, the magnitude of the first magnetic flux density B1 is greater than that of the second magnetic flux density B2. Accordingly, in this case, formula (20) and formula (52) are satisfied.

$$\sqrt{Tx1^2 + Ty1^2 + Tz1^2} > \sqrt{Tx2^2 + Ty2^2 + Tz2^2} \qquad \ldots (52)$$

In the case expressed by formula (18), the Y component Ty1 of the first magnetic flux density B1 detected by the first magnetic sensor 52 is a value less than zero, and the Y component Ty2 of the second magnetic flux density B2 detected by the second magnetic sensor 54 is a value less than or equal to zero. Further, the magnitude of the first magnetic flux density B1 is less than that of the second magnetic flux density B2. Accordingly, in this case, formula (20) and formula (53) are satisfied.

$$\sqrt{Tx1^2 + Ty1^2 + Tz1^2} < \sqrt{Tx2^2 + Ty2^2 + Tz2^2} \qquad \ldots (53)$$

In the case that the condition expressed by formula (20) and the condition expressed by formula (52) are satisfied, the calculation circuit 56 calculates the position (Xm, C, Zm) of the magnet 38 by formula (54), formula (55), and formula (56). In this case, the denominator DIV2 in formula (54), formula (55), and formula (56) is expressed by formula (57).

$$Xm = P \times \frac{\frac{Ty1}{|Ty1|} \times \frac{Tx1}{\sqrt{Ty1^2+Tz1^2}} + \sqrt{\left(\frac{Tx1}{\sqrt{Ty1^2+Tz1^2}}\right)^2 + 1}}{DIV2} + \frac{P}{2} \qquad \ldots (54)$$

$$C = P \times \frac{1}{DIV2} \times \frac{Ty1}{\sqrt{Ty1^2 + Tz1^2}} \qquad \ldots(55)$$

$$Zm = P \times \frac{1}{DIV2} \times \frac{Tz1}{\sqrt{Ty1^2 + Tz1^2}} \qquad \ldots(56)$$

$$DIV2 = \frac{Ty2}{|Ty2|} \times \frac{Tx2}{\sqrt{Ty2^2 + Tz2^2}} + \sqrt{\left(\frac{Tx2}{\sqrt{Ty2^2 + Tz2^2}}\right)^2 + 1} - \left(\frac{Ty1}{|Ty1|} \times \frac{Tx1}{\sqrt{Ty1^2 + Tz1^2}} + \sqrt{\left(\frac{Tx1}{\sqrt{Ty1^2 + Tz1^2}}\right)^2 + 1}\right) \qquad \ldots(57)$$

In the case that the condition expressed by formula (20) and the condition expressed by formula (53) are satisfied, the calculation circuit 56 calculates the position (Xm, C, Zm) of the magnet 38 by formula (58), formula (59), and formula (60). In this case, the denominator DIV3 in formula (58), formula (59), and formula (60) is expressed by formula (61).

$$Xm = P \times \frac{\frac{Ty1}{|Ty1|} \times \frac{Tx1}{\sqrt{Ty1^2 + Tz1^2}} - \sqrt{\left(\frac{Tx1}{\sqrt{Ty1^2 + Tz1^2}}\right)^2 + 1}}{DIV3} + \frac{P}{2} \qquad \ldots(58)$$

$$C = P \times \frac{1}{DIV3} \times \frac{Ty1}{\sqrt{Ty1^2 + Tz1^2}} \qquad \ldots(59)$$

$$Zm = P \times \frac{1}{DIV3} \times \frac{Tz1}{\sqrt{Ty1^2 + Tz1^2}} \qquad \ldots(60)$$

$$DIV3 = \frac{Ty2}{|Ty2|} \times \frac{Tx2}{\sqrt{Ty2^2 + Tz2^2}} - \sqrt{\left(\frac{Tx2}{\sqrt{Ty2^2 + Tz2^2}}\right)^2 + 1} - \left(\frac{Ty1}{|Ty1|} \times \frac{Tx1}{\sqrt{Ty1^2 + Tz1^2}} - \sqrt{\left(\frac{Tx1}{\sqrt{Ty1^2 + Tz1^2}}\right)^2 + 1}\right) \qquad \ldots(61)$$

(Exemplary Modification 3)

In the aforementioned Exemplary Modification 2, the Y coordinate value C and the Z coordinate value Zm of the position of the magnet 38, which are obtained respectively using formula (49) and formula (50) in the case that the condition expressed by formula (19) is satisfied, may also be used in the case that the condition expressed by formula (20) is satisfied. In the present exemplary modification, by substituting into formula (62) the Y coordinate value C and the Z coordinate value Zm of the position of the magnet 38, which are respectively obtained using formula (49) and formula (50), then, the calculation circuit 56 calculates the X coordinate value Xm of the position of the magnet 38 in the case that formula (20) and formula (52) are satisfied.

$$Xm = \sqrt{C^2 + Zm^2} \times \left(\frac{Ty1}{|Ty1|} \times \frac{Tx1}{\sqrt{Ty1^2 + Tz1^2}} + \sqrt{\left(\frac{Tx1}{\sqrt{Ty1^2 + Tz1^2}}\right)^2 + 1}\right) + \frac{P}{2} \qquad \ldots(62)$$

By substituting into formula (63) the Y coordinate value C and the Z coordinate value Zm of the position of the magnet 38, which are respectively obtained using formula (49) and formula (50), then, the calculation circuit 56 calculates the X coordinate value Xm of the position of the magnet 38 in the case that formula (20) and formula (53) are satisfied.

$$Xm = \sqrt{C^2 + Zm^2} \times \left( \frac{Ty2}{|Ty2|} \times \frac{Tx2}{\sqrt{Ty2^2 + Tz2^2}} - \sqrt{\left(\frac{Tx2}{\sqrt{Ty2^2 + Tz2^2}}\right)^2 + 1} \right) - \frac{P}{2} \qquad \ldots (63)$$

(Exemplary Modification 4)

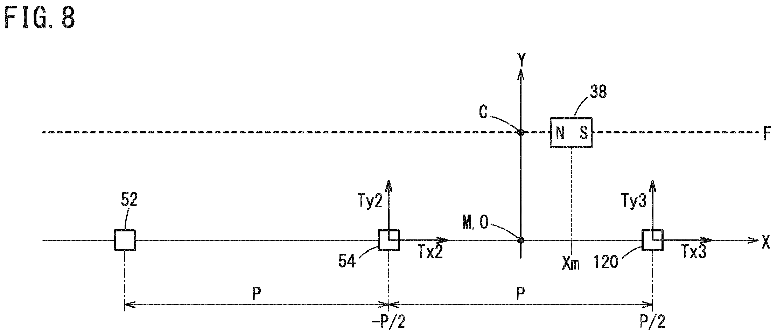

Three or more of the magnetic sensors may be installed on the cylinder 32. In that case, the three or more of the magnetic sensors are arranged at an interval of the predetermined distance P in the X-axis direction. FIG. 8 is a diagram for the purpose of describing calculation of the position of the magnet 38, in the case that a third magnetic sensor 120 is arranged in addition to the first magnetic sensor 52 and the second magnetic sensor 54. In FIG. 8, the first magnetic sensor 52, the second magnetic sensor 54, and the third magnetic sensor 120 are positioned on the X-axis while being spaced apart from each other by the predetermined distance P. The third magnetic sensor 120 is arranged while being spaced apart from the second magnetic sensor 54 by the predetermined distance P in the X-axis direction. In FIG. 8, the third magnetic sensor 120 is arranged on an opposite side of the first magnetic sensor 52 with the second magnetic sensor 54 being interposed therebetween.

In the embodiment described above, using the first magnetic flux density B1 detected by the first magnetic sensor 52, the second magnetic flux density B2 detected by the second magnetic sensor 54, and the predetermined distance P, the position of the magnet 38 is calculated by the calculation circuit 56. Further, according to the present modification, using the second magnetic flux density B2 detected by the second magnetic sensor 54, the third magnetic flux density B3 detected by the third magnetic sensor 120, and the predetermined distance P, the position of the magnet 38 is calculated by the calculation circuit 56.

Calculation of the position of the magnet 38 using the second magnetic flux density B2, the third magnetic flux density B3, and the predetermined distance P is carried out in the same manner as calculation of the position of the magnet 38 using the first magnetic flux density B1, the second magnetic flux density B2, and the predetermined distance P. The origin point O of the XY coordinate plane is the midpoint M between the position of the second magnetic sensor 54 and the position of the third magnetic sensor 120. The X coordinate value of the position of the second magnetic sensor 54 is -P/2, and the Y coordinate value is zero. The X coordinate value of the position of the third magnetic sensor 120 is P/2, and the Y coordinate value is zero in the same manner as the second magnetic sensor 54. The magnet 38 is at a position expressed by the X coordinate value Xm and the Y coordinate value C. The X coordinate value Xm and the Y coordinate value C of the position of the magnet 38 are expressed by formula (33) to formula (38).

The trajectory F of the magnet 38 when the magnet 38 moves relatively with respect to the cylinder 32 is shown in FIG. 8. The trajectory F, which extends in the direction in which the magnet 38 moves, is a straight line in the same direction as the direction in which the first magnetic sensor 52, the second magnetic sensor 54, and the third magnetic sensor 120 are arranged. More specifically, as shown in FIG. 8, the trajectory F of the magnet 38 is parallel to the X-axis on which the first magnetic sensor 52, the second magnetic sensor 54, and the third magnetic sensor 120 are arranged.

In the case that a plurality of the magnetic sensors are arranged at intervals of the predetermined distance P in the X-axis direction, the calculation circuit 56 calculates the position of the magnet 38, using the magnetic flux densities detected by any two of the magnetic sensors that are adjacent to each other, and the predetermined distance P. By using formula (33) to formula (38) with one of the two magnetic sensors being treated as the first magnetic sensor 52, and the other of the two magnetic sensors being treated as the second magnetic sensor 54, the position of the magnet 38 is calculated.

An exemplary case is described in which the two of the magnetic sensors that are adjacent to each other are the second magnetic sensor 54 and the third magnetic sensor 120 shown in FIG. 8. By treating the second magnetic sensor 54 shown in FIG. 8 as the first magnetic sensor 52, and treating the third magnetic sensor 120 shown in FIG. 8 as the second magnetic sensor 54, formula (33) to formula (38) are used.

In that case, instead of the ratio between the X component Tx1 and the Y component Ty1 of the first magnetic flux density B1, the ratio between the X component Tx2 and the Y component Ty2 of the second magnetic flux density B2 is used as the first ratio R1 in formula (33) to formula (38). As the second ratio R2 in formula (33) to formula (38), instead of the ratio between the X component Tx2 and the Y component Ty2 of the second magnetic flux density B2, the ratio between the X component Tx3 and the Y component Ty3 of the third magnetic flux density B3 is used. In this manner, the calculation circuit 56 is capable of calculating the position of the magnet 38 using the magnetic flux densities detected by any two of the magnetic sensors that are adjacent to each other, and the predetermined distance P.

(Exemplary Modification 5)

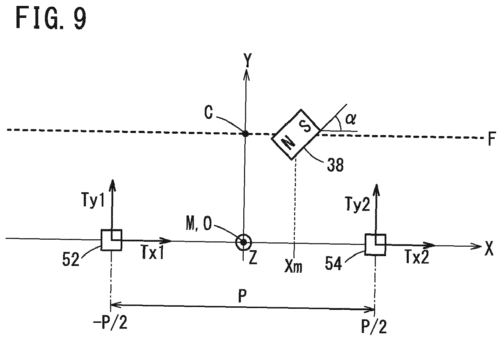

The magnet 38 moves relatively in the X-axis direction with respect to the cylinder 32. However, the two magnetic poles of the magnet 38 need not necessarily be arranged alongside one another in the X-axis direction. FIG. 9 is a diagram showing an example in which a direction in which the two magnetic poles possessed by the magnet 38 are arranged alongside one another does not coincide with the X-axis direction. FIG. 9 differs from FIG. 4, in that the direction in which the two magnetic poles of the magnet 38 are arranged alongside one another and the X-axis direction form an angle of the angle $\alpha$ on the XY coordinate plane. Stated otherwise, in comparison with FIG. 4, in FIG. 9, a state is shown in which, in a right-handed XYZ coordinate space, the direction in which the two magnetic poles of the magnet 38 are arranged alongside one another is rotated by the angle $\alpha$ about the Z-axis, taking the X-axis direction as a reference. The X-axis, the Y-axis, and the Z-axis are perpendicular to each other. In FIG. 9, descriptions having the same content as in FIG. 4 are omitted.

In the example shown in FIG. 9, the Z component Tz of the magnetic flux density B does not change due to being rotated in the direction in which the two magnetic poles of the magnet 38 are arranged alongside one another. The X component Tx and the Y component Ty of the magnetic flux density B are converted by formula (64) into an X component Txa and a Y component Tya. The calculation circuit 56 calculates the position of the magnet 38 using the X component Txa and the Y component Tya which are obtained in this manner, and the Z component Tz.

$$\begin{pmatrix} Txa \\ Tya \end{pmatrix} = \begin{pmatrix} \cos(-\alpha) & -\sin(-\alpha) \\ \sin(-\alpha) & \cos(-\alpha) \end{pmatrix} \begin{pmatrix} Tx \\ Ty \end{pmatrix} \qquad \dots (64)$$

Moreover, also in the case in which the arrangement direction of the two magnetic poles possessed by the magnet 38 and the Y-axis direction form the angle $\alpha$ on the YZ coordinate plane, the position of the magnet 38 can be calculated similarly. In that case, in the right-handed XYZ coordinate space, the direction in which the two magnetic poles of the magnet 38 are arranged alongside one another is a state of being rotated by the angle $\alpha$ about the X-axis, taking the Y-axis direction as a reference.

Further, also in the case in which the arrangement direction of the two magnetic poles possessed by the magnet 38 and the Z-axis direction form the angle $\alpha$ on the XZ coordinate plane, the position of the magnet 38 can be calculated similarly. In that case, in the right-handed XYZ coordinate space, the direction in which the two magnetic poles of the magnet 38 are arranged alongside one another is a state of being rotated by the angle $\alpha$ about the Y-axis, taking the Z-axis direction as a reference.

Any one from among the X-axis, the Y-axis, and the Z-axis of the XYZ coordinate space defines a U-axis, and the two axes other than the U-axis define a V-axis and a W-axis. Taking the U-axis direction in which the U-axis extends as a reference, the direction in which the two magnetic poles possessed by the magnet 38 are arranged alongside one another is a state of being rotated by the angle $\alpha$ about the W-axis. In that case, the U component Tu in the U-axis direction and the V-component Tv in the V-axis direction of the magnetic flux density B are rotationally transformed by formula (65) into a U component Tua and a V component Tva. Using the U component Tua and the V component Tva which are obtained in this manner, and a W component Tw of the magnetic field density B, the calculation circuit 56 is capable of calculating the position of the magnet 38.

$$\begin{pmatrix} Tua \\ Tva \end{pmatrix} = \begin{pmatrix} \cos(-\alpha) & -\sin(-\alpha) \\ \sin(-\alpha) & \cos(-\alpha) \end{pmatrix} \begin{pmatrix} Tu \\ Tv \end{pmatrix} \qquad \dots (65)$$

In the example shown in FIG. 9, the U-axis corresponds to the X-axis, the V-axis corresponds to the Y-axis, and the W-axis corresponds to the Z-axis. The direction in which the two magnetic poles possessed by the magnet 38 are arranged alongside one another and the X-axis direction form the angle $\alpha$. The direction in which the two magnetic poles possessed by the magnet 38 are arranged alongside one another is a state of being rotated by the angle $\alpha$ about the Z-axis.

In the case of the first magnetic sensor 52, the U component Tu and the V component Tv in equation (65) correspond respectively to the X component Tx1 and the Y component Ty1 of the first magnetic flux density B1 detected by the first magnetic sensor 52. In the case of the second magnetic sensor 54, the U component Tu and the V component Tv in equation (65) correspond respectively to the X component Tx2 and the Y component Ty2 of the second magnetic flux density B2 detected by the second magnetic sensor 54.

By the rotational transformation shown in formula (66) which corresponds to formula (65), an X component Txa1 and a Y component Tya1 are obtained based on the X component Tx1 and the Y component Ty1 of the first magnetic flux density B1. By the rotational transformation shown in formula (67) which corresponds to formula (65), an X component Txa2 and a Y component Tya2 are obtained based on the X component Tx2 and the Y component Ty2 of the second magnetic flux density B2.

$$\begin{pmatrix} Txa1 \\ Tya1 \end{pmatrix} = \begin{pmatrix} \cos(-\alpha) & -\sin(-\alpha) \\ \sin(-\alpha) & \cos(-\alpha) \end{pmatrix} \begin{pmatrix} Tx1 \\ Ty1 \end{pmatrix} \qquad \ldots (66)$$

$$\begin{pmatrix} Txa2 \\ Tya2 \end{pmatrix} = \begin{pmatrix} \cos(-\alpha) & -\sin(-\alpha) \\ \sin(-\alpha) & \cos(-\alpha) \end{pmatrix} \begin{pmatrix} Tx2 \\ Ty2 \end{pmatrix} \qquad \ldots (67)$$

Due to the rotational conversion shown in formula (66) and formula (67), the direction in which the two magnetic poles of the magnet 38 are arranged alongside one another virtually coincides with the X-axis direction. The ratio between the X component Txa1 and the Y component Tya1 obtained by the rotational transformation shown in formula (66) defines a first ratio R1. The ratio between the X component Txa2 and the Y component Tya2 obtained by the rotational transformation shown in formula (67) defines a second ratio R2. Using the first ratio R1 and the second ratio R2 which are obtained in this manner, the calculation circuit 56 is capable of calculating the position of the magnet 38 in accordance with formula (33) to formula (38).

[Inventions Capable of Being Obtained from the Embodiment]

A description will be given below concerning the inventions that are capable of being grasped from the above-described embodiment and the exemplary modifications.

(1) The position calculation device (10) calculates the position of the magnet (38) installed on the moving body which is capable of moving relatively in the first direction with respect to the fixed member, the position calculation device including the first magnetic sensor (52) and the second magnetic sensor (54) installed on the fixed member, and arranged apart from each other by the predetermined distance (P) in the first direction, and which detect the magnetic flux density (B) of the magnetic field generated by the magnet, and the calculation circuit (56) that calculates the position of the magnet, using the first ratio (R1) between the first component in the first direction and the second component in the second direction perpendicular to the first direction, of the first magnetic flux density (B1) detected by the first magnetic sensor, the second ratio (R2) between the third component in the first direction and the fourth component in the second direction, of the second magnetic flux density (B2) detected by the second magnetic sensor, and the predetermined distance. In accordance with such features, it is possible to accurately calculate the position of the magnet.
(2) The two magnetic poles possessed by the magnet may be arranged alongside one another in the first direction, and the calculation circuit may calculate the position of the magnet, in accordance with whether or not the second component is greater than or equal to zero, whether or not the fourth component is greater than or equal to zero, and the order in which the two magnetic poles are arranged. In the case that the order in which the two magnetic poles possessed by the magnet are arranged is already known, in accordance therewith, the position of the magnet can be accurately and easily calculated.
(3) The calculation circuit may calculate the position of the magnet, in accordance with whether or not the product of the second component and the fourth component is less than zero, and in the case that the product of the second component and the fourth component is greater than or equal to zero, the calculation circuit may calculate the position of the magnet in accordance with whether or not the magnitude of the first magnetic flux density is greater than the magnitude of the second magnetic flux density. In accordance with such features, even in the case that the order in which the two magnetic poles possessed by the magnet is not yet known, the position of the magnet can be accurately and easily calculated.
(4) In the case that the product of the second component and the fourth component is less than zero, the calculation circuit may calculate the position Xm of the magnet in the first direction by formula (33) using the first ratio R1, the second ratio R2, and the predetermined distance P, and the position Xm of the magnet in the first direction may be a position for a case in which the midpoint (M) between the first magnetic sensor and the second magnetic sensor in the first direction is set to the origin point (O). In accordance with such features, the position of the magnet can be accurately calculated regardless of the type and the individuality of the actuator product.
(5) In the case that the product of the second component and the fourth component is less than zero, the calculation circuit may calculate the position C of the magnet in the second direction by formula (34) using the first ratio R1, the second ratio R2, and the predetermined distance P, and the position C of the magnet in the second direction may be a position for a case in which the midpoint between the first magnetic sensor and the second magnetic sensor in the first direction is set to the origin point. In accordance with such features, the position of the magnet can be accurately calculated regardless of the position where the magnet is installed.

(6) In the case that the product of the second component and the fourth component is greater than or equal to zero, and the magnitude of the first magnetic flux density is greater than the magnitude of the second magnetic flux density, the calculation circuit may calculate the position Xm of the magnet in the first direction by formula (35) using the first ratio R1, the second ratio R2, and the predetermined distance P, and in the case that the product of the second component and the fourth component is greater than or equal to zero, and the magnitude of the first magnetic flux density is less than the magnitude of the second magnetic flux density, the calculation circuit may calculate the position Xm of the magnet in the first direction by formula (37) using the first ratio R1, the second ratio R2, and the predetermined distance P. In accordance with such features, even in the case that, in relation to the first direction, the magnet is positioned in a location other than in a segment between the first magnetic sensor and the second magnetic sensor, the position of the magnet can be accurately calculated.

(7) In the case that the product of the second component and the fourth component is greater than or equal to zero, and the magnitude of the first magnetic flux density is greater than the magnitude of the second magnetic flux density, the calculation circuit may calculate the position C of the magnet in the second direction by formula (36) using the first ratio R1, the second ratio R2, and the predetermined distance P, and in the case that the product of the second component and the fourth component is greater than or equal to zero, and the magnitude of the first magnetic flux density is less than the magnitude of the second magnetic flux density, the calculation circuit may calculate the position C of the magnet in the second direction by formula (38) using the first ratio R1, the second ratio R2, and the predetermined distance P. In accordance with such features, even in the case that, in relation to the first direction, the magnet is positioned in a location other than in a segment between the first magnetic sensor and the second magnetic sensor, the position of the magnet can be accurately calculated.

(8) In the case that the magnet, the first magnetic sensor, and the second magnetic sensor are arranged on the XY coordinate plane in which the first direction is the X-axis direction, and the second direction is the Y-axis direction, the first component and the second component are the X component Tx1 in the X-axis direction and the Y component Ty1 in the Y-axis direction of the first magnetic flux density detected by the first magnetic sensor on the XY coordinate plane, and the third component and the fourth component are the X component Tx2 in the X-axis direction and the Y component Ty2 in the Y-axis direction of the second magnetic flux density detected by the second magnetic sensor on the XY coordinate plane, in the case that the product of the second component and the fourth component is greater than or equal to zero, and the magnitude of the first magnetic flux density is greater than the magnitude of the second magnetic flux density, the calculation circuit may calculate the position Xm of the magnet in the X-axis direction with respect to the midpoint, by formula (27) using the X component Tx1 of the first magnetic flux density, the Y component Ty1 of the first magnetic flux density, and the position C of the magnet in the Y-axis direction with respect to the midpoint as calculated by the formula (34), and in the case that the product of the second component and the fourth component is greater than or equal to zero, and the magnitude of the first magnetic flux density is less than the magnitude of the second magnetic flux density, the calculation circuit may calculate the position Xm of the magnet in the X-axis direction with respect to the midpoint, by formula (30) using the X component Tx2 of the second magnetic flux density, the Y component Ty2 of the second magnetic flux density, and the position C of the magnet in the Y-axis direction with respect to the midpoint as calculated by the formula (34). In accordance with such features, it is possible to more accurately calculate the position of the magnet.

(9) In the case that the magnet, the first magnetic sensor, and the second magnetic sensor are arranged in the XYZ coordinate space formed by the X-axis direction which is the first direction, the Y-axis direction perpendicular to the X-axis direction and which differs from the second direction, and the Z-axis direction perpendicular to both the X-axis direction and the Y-axis direction and which differs from the second direction, the first component is an X component Tx1 in the X-axis direction of the first magnetic flux density detected by the first magnetic sensor in the XYZ coordinate space, the second component is a composite component obtained by synthesizing the Y component Ty1 in the Y-axis direction of the first magnetic flux density, and the Z component Tz1 in the Z-axis direction of the first magnetic flux density, the third component is an X component Tx2 in the X-axis direction of the second magnetic flux density detected by the second magnetic sensor in the XYZ coordinate space, and the fourth component is a composite component obtained by synthesizing the Y component Ty2 in the Y-axis direction of the second magnetic flux density, and the Z component Tz2 in the Z-axis direction of the second magnetic flux density, in a case that a product of the Y component Ty1 of the first magnetic flux density and the Y component Ty2 of the second magnetic flux density is less than zero, the calculation circuit may calculate the position Xm of the magnet in the X-axis direction by formula (48) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, may calculate the position C of the magnet in the Y-axis direction by formula (49) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, may calculate the position Zm of the magnet in the Z-axis direction by formula (50) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, the denominator DIV1 in the formula (48), the formula (49), and the formula (50) may be expressed by formula (51), and the position Xm of the magnet in the X-axis direction, the position C of the magnet in the Y-axis direction, and the position Zm of the magnet in the Z-axis direction may be positions for a case in which a midpoint between the first magnetic sensor and the second magnetic sensor in the first direction is set to the origin point. In accordance with such features, it is possible to accurately calculate the three-dimensional position of the magnet.

(10) In the case that the product of the Y component Ty1 of the first magnetic flux density and the Y component Ty2 of the second magnetic flux density is greater than or equal to zero, and the magnitude of the first magnetic flux density is greater than the magnitude of the second magnetic flux density, the calculation circuit calculates the position Xm of the magnet in the X-axis direction with respect to the midpoint, by formula (54) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, calculates the position C of the magnet in the Y-axis direction with respect to the midpoint, by formula (55) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, calculates the position Zm of the magnet in the Z-axis direction with respect to the midpoint, by formula (56) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, and the denominator DIV2 in the formula (54), the formula (55), and the formula (56) is expressed by formula (57), in the case that the product of the Y component Ty1 of the first magnetic flux density and the Y component Ty2 of the second magnetic flux density is greater than or equal to zero, and the magnitude of the first magnetic flux density is less than the magnitude of the second magnetic flux density, the calculation circuit calculates the position Xm of the magnet in the X-axis direction with respect to the midpoint, by formula (58) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, calculates the position C of the magnet in the Y-axis direction with respect to the midpoint, by formula (59) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, calculates the position Zm of the magnet in the Z-axis direction with respect to the midpoint, by formula (60) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P, and the denominator DIV3 in the formula (58), the formula (59), and the formula (60) is expressed by formula (61). In accordance with such features, the three-dimensional position of the magnet can be calculated more accurately.

(11) In the case that the product of the Y component Ty1 of the first magnetic flux density and the Y component Ty2 of the second magnetic flux density is greater than or equal to zero, and the magnitude of the first magnetic flux density is greater than the magnitude of the second magnetic flux density, the calculation circuit may calculate the position Xm of the magnet in the X-axis direction with respect to the midpoint, by the formula (62) using the X component Tx1 of the first magnetic flux density, the Y component Ty1 of the first magnetic flux density in the Y-axis direction, the Z component Tz1 of the first magnetic flux density in the Z-axis direction, the position C of the magnet in the Y-axis direction with respect to the midpoint as calculated by the formula (49), and the position Zm of the magnet in the Z-axis direction with respect to the midpoint as calculated by the formula (50), and in the case that the product of the Y component Ty1 of the first magnetic flux density and the Y component Ty2 of the second magnetic flux density is greater than or equal to zero, and the magnitude of the first magnetic flux density is less than the magnitude of the second magnetic flux density, the calculation circuit may calculate the position Xm of the magnet in the X-axis direction with respect to the midpoint, by formula (63) using the X component Tx2 of the second magnetic flux density, the Y component Ty2 of the second magnetic flux density, the Z component Tz2 of the second magnetic flux density, the position C of the magnet in the Y-axis direction with respect to the midpoint as calculated by the formula (49), and the position Zm of the magnet in the Z-axis direction with respect to the midpoint as calculated by the formula (50). In accordance with such features, the three-dimensional position of the magnet can be calculated more accurately.

(12) In the case that the plurality of the magnetic sensors installed on the fixed member are arranged at intervals of the predetermined distance in the first direction, among the plurality of the magnetic sensors, one of two magnetic sensors that are adjacent to each other may be the first magnetic sensor, and the other of the two magnetic sensors may be the second magnetic sensor. In accordance with such features, using the plurality of the magnetic sensors, the position of the magnet can be calculated more accurately.

(13) In the XYZ coordinate space formed by the X-axis direction which is the first direction, the Y-axis direction which is perpendicular to the X-axis direction, and the Z-axis direction which is perpendicular to both the X-axis direction and the Y-axis direction, in the case that the direction in which the two magnetic poles of the magnet are arranged alongside one another is in a state of being rotated by the angle $\alpha$ about the W-axis, taking as a reference the U-axis direction in which the U-axis extends, the U-axis being one of the X-axis, the Y-axis, and the Z-axis of the XYZ coordinate space, the W-axis being a coordinate axis other than the U-axis, from among the X-axis, the Y-axis, and the Z-axis, the calculation circuit may calculate the position of the magnet using the U component Tua and the V component Tva obtained by transforming by formula (65) the U component Tu of the magnetic flux density in the U-axis direction and the V component Tv of the magnetic flux density in the V-axis direction, in which the V-axis extends, wherein the V-axis is a coordinate axis other than the U-axis and the W-axis from among the X-axis, the Y-axis, and Z-axis. In accordance with such features, the position of the magnet can be calculated more accurately, even in the case that the direction in which the two poles of the magnet are arranged is oriented in any direction.

(14) Each of the first magnetic sensor and the second magnetic sensor may be a Hall sensor that detects the magnetic flux density based on a voltage generated according to the Hall effect. In accordance with this feature, the magnetic flux densities in multiple axial directions are detected, and therefore, the position of the magnet can be accurately calculated.

(15) There may further be provided the attachment member (100) configured to be installed in the attachment groove (90) formed in the fixed member. In accordance with this feature, since the position calculation device is kept stable, the position of the magnet can be calculated accurately.

**Claims**

1. A position calculation device (10) configured to calculate a position of a magnet (38) installed on a moving body that is configured to move relatively in a first direction with respect to a fixed member, the position calculation device comprising:

   a first magnetic sensor (52) and a second magnetic sensor (54) installed on the fixed member, and arranged apart from each other by a predetermined distance (P) in the first direction, and configured to detect a magnetic flux density (B) of a magnetic field generated by the magnet; and
   a calculation circuit (56) configured to calculate the position of the magnet, using a first ratio (R1) between a first component in the first direction and a second component in a second direction perpendicular to the first direction, of a first magnetic flux density (B1) detected by the first magnetic sensor, a second ratio (R2) between a third component in the first direction and a fourth component in the second direction, of a second magnetic flux density (B2) detected by the second magnetic sensor, and the predetermined distance.

2. The position calculation device according to claim 1, wherein:

   two magnetic poles possessed by the magnet are arranged alongside one another in the first direction; and
   the calculation circuit calculates the position of the magnet, in accordance with whether or not the second component is greater than or equal to zero, whether or not the fourth component is greater than or equal to zero, and an order in which the two magnetic poles are arranged.

3. The position calculation device according to claim 1, wherein:

   the calculation circuit calculates the position of the magnet, in accordance with whether or not a product of the second component and the fourth component is less than zero; and

in a case that the product of the second component and the fourth component is greater than or equal to zero, the calculation circuit calculates the position of the magnet in accordance with whether or not a magnitude of the first magnetic flux density is greater than a magnitude of the second magnetic flux density.

4. The position calculation device according to claim 3, wherein:

in a case that the product of the second component and the fourth component is less than zero, the calculation circuit calculates the position Xm of the magnet in the first direction by formula (E1) using the first ratio R1, the second ratio R2, and the predetermined distance P; and
the position Xm of the magnet in the first direction is a position for a case in which a midpoint (M) between the first magnetic sensor and the second magnetic sensor in the first direction is set to an origin point (O):

$$Xm = P \times \frac{R1 - \sqrt{R1^2 + 1}}{R2 + \sqrt{R2^2 + 1} - \left(R1 - \sqrt{R1^2 + 1}\right)} + \frac{P}{2} \qquad \dots (\text{E1}).$$

5. The position calculation device according to claim 4, wherein:

in the case that the product of the second component and the fourth component is less than zero, the calculation circuit calculates the position C of the magnet in the second direction by formula (E2) using the first ratio R1, the second ratio R2, and the predetermined distance P; and
the position C of the magnet in the second direction is a position for a case in which the midpoint between the first magnetic sensor and the second magnetic sensor in the first direction is set to the origin point:

$$C = P \times \frac{1}{R2 + \sqrt{R2^2 + 1} - \left(R1 - \sqrt{R1^2 + 1}\right)} \qquad \dots (\text{E2}).$$

6. The position calculation device according to claim 4, wherein:

in a case that the product of the second component and the fourth component is greater than or equal to zero, and the magnitude of the first magnetic flux density is greater than the magnitude of the second magnetic flux density, the calculation circuit calculates the position Xm of the magnet in the first direction by formula (E3) using the first ratio R1, the second ratio R2, and the predetermined distance P; and
in a case that the product of the second component and the fourth component is greater than or equal to zero, and the magnitude of the first magnetic flux density is less than the magnitude of the second magnetic flux density, the calculation circuit calculates the position Xm of the magnet in the first direction by formula (E4) using the first ratio R1, the second ratio R2, and the predetermined distance P:

$$Xm = P \times \frac{R1 + \sqrt{R1^2 + 1}}{R2 + \sqrt{R2^2 + 1} - \left(R1 + \sqrt{R1^2 + 1}\right)} + \frac{P}{2} \qquad \dots (\text{E3})$$

$$Xm = P \times \frac{R1 - \sqrt{R1^2 + 1}}{R2 - \sqrt{R2^2 + 1} - \left(R1 - \sqrt{R1^2 + 1}\right)} - \frac{P}{2} \qquad \dots (\text{E4}).$$

7. The position calculation device according to claim 6, wherein:

in the case that the product of the second component and the fourth component is greater than or equal to zero, and the magnitude of the first magnetic flux density is greater than the magnitude of the second magnetic flux density, the calculation circuit calculates the position C of the magnet in the second direction by formula (E5) using the first ratio R1, the second ratio R2, and the predetermined distance P; and
in the case that the product of the second component and the fourth component is greater than or equal to zero, and the magnitude of the first magnetic flux density is less than the magnitude of the second magnetic flux density, the calculation circuit calculates the position C of the magnet in the second direction by formula (E6) using the first ratio R1, the second ratio R2, and the predetermined distance P:

$$C = P \times \frac{1}{R2 + \sqrt{R2^2 + 1} - \left(R1 + \sqrt{R1^2 + 1}\right)} \qquad \dots (E5)$$

$$C = P \times \frac{1}{R2 - \sqrt{R2^2 + 1} - \left(R1 - \sqrt{R1^2 + 1}\right)} \qquad \dots (E6) \,.$$

**8.** The position calculation device according to claim 5, wherein:

in a case that the magnet, the first magnetic sensor, and the second magnetic sensor are arranged on an XY coordinate plane in which the first direction is an X-axis direction and the second direction is an Y-axis direction, the first component and the second component are an X component Tx1 in the X-axis direction and a Y component Ty1 in the Y-axis direction of the first magnetic flux density detected by the first magnetic sensor on the XY coordinate plane, and the third component and the fourth component are an X component Tx2 in the X-axis direction and a Y component Ty2 in the Y-axis direction of the second magnetic flux density detected by the second magnetic sensor on the XY coordinate plane;
in a case that the product of the second component and the fourth component is greater than or equal to zero, and the magnitude of the first magnetic flux density is greater than the magnitude of the second magnetic flux density, the calculation circuit calculates the position Xm of the magnet in the X-axis direction with respect to the midpoint, by formula (E7) using the X component Tx1 of the first magnetic flux density, the Y component Ty1 of the first magnetic flux density, and the position C of the magnet in the Y-axis direction with respect to the midpoint as calculated by the formula (E2); and
in a case that the product of the second component and the fourth component is greater than or equal to zero, and the magnitude of the first magnetic flux density is less than the magnitude of the second magnetic flux density, the calculation circuit calculates the position Xm of the magnet in the X-axis direction with respect to the midpoint, by formula (E8) using the X component Tx2 of the second magnetic flux density, the Y component Ty2 of the second magnetic flux density, and the position C of the magnet in the Y-axis direction with respect to the midpoint as calculated by the formula (E2):

$$Xm = C \times \left( \frac{Tx1}{Ty1} + \sqrt{\left(\frac{Tx1}{Ty1}\right)^2 + 1} \right) + \frac{P}{2} \qquad \dots (E7)$$

$$Xm = C \times \left( \frac{Tx2}{Ty2} - \sqrt{\left(\frac{Tx2}{Ty2}\right)^2 + 1} \right) - \frac{P}{2} \qquad \dots (E8) \,.$$

**9.** The position calculation device according to claim 1, wherein:

in a case that the magnet, the first magnetic sensor, and the second magnetic sensor are arranged in an XYZ coordinate space formed by an X-axis direction which is the first direction, a Y-axis direction perpendicular to the X-axis direction and which differs from the second direction, and a Z-axis direction perpendicular to both the X-axis direction and the Y-axis direction and which differs from the second direction, the first component is an X component Tx1 in the X-axis direction of the first magnetic flux density detected by the first magnetic sensor in the XYZ coordinate space, the second component is a composite component obtained by synthesizing a Y component Ty1 in the Y-axis direction of the first magnetic flux density and a Z component Tz1 in the Z-axis direction of the first magnetic flux density, the third component is an X component Tx2 in the X-axis direction of the second magnetic flux density detected by the second magnetic sensor in the XYZ coordinate space, and the fourth component is a composite component obtained by synthesizing a Y component Ty2 in the Y-axis direction of the second magnetic flux density and a Z component Tz2 in the Z-axis direction of the second magnetic flux density;
in a case that a product of the Y component Ty1 of the first magnetic flux density and the Y component Ty2 of the second magnetic flux density is less than zero, the calculation circuit:

calculates the position Xm of the magnet in the X-axis direction by formula (E9) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;

calculates the position C of the magnet in the Y-axis direction by formula (E10) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;

calculates the position Zm of the magnet in the Z-axis direction by formula (E11) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;

a denominator DIV1 in the formula (E9), the formula (E10), and the formula (E11) is expressed by formula (E12); and

the position Xm of the magnet in the X-axis direction, the position C of the magnet in the Y-axis direction, and the position Zm of the magnet in the Z-axis direction are positions for a case in which a midpoint between the first magnetic sensor and the second magnetic sensor in the first direction is set to an origin point:

$$Xm = P \times \frac{\frac{Ty1}{|Ty1|} \times \frac{Tx1}{\sqrt{Ty1^2+Tz1^2}} - \sqrt{\left(\frac{Tx1}{\sqrt{Ty1^2+Tz1^2}}\right)^2 + 1}}{DIV1} + \frac{P}{2} \qquad \ldots(E9)$$

$$C = P \times \frac{1}{DIV1} \times \frac{Ty1}{\sqrt{Ty1^2+Tz1^2}} \qquad \ldots(E10)$$

$$Zm = P \times \frac{1}{DIV1} \times \frac{Tz1}{\sqrt{Ty1^2+Tz1^2}} \qquad \ldots(E11)$$

$$DIV1 = \frac{Ty2}{|Ty2|} \times \frac{Tx2}{\sqrt{Ty2^2+Tz2^2}} + \sqrt{\left(\frac{Tx2}{\sqrt{Ty2^2+Tz2^2}}\right)^2 + 1} - \left(\frac{Ty1}{|Ty1|} \times \frac{Tx1}{\sqrt{Ty1^2+Tz1^2}} - \sqrt{\left(\frac{Tx1}{\sqrt{Ty1^2+Tz1^2}}\right)^2 + 1}\right) \quad \ldots(E12).$$

**10.** The position calculation device according to claim 9, wherein:

in a case that the product of the Y component Ty1 of the first magnetic flux density and the Y component Ty2 of the second magnetic flux density is greater than or equal to zero, and a magnitude of the first magnetic flux density is greater than a magnitude of the second magnetic flux density, the calculation circuit:

calculates the position Xm of the magnet in the X-axis direction with respect to the midpoint, by formula (E13) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;

calculates the position C of the magnet in the Y-axis direction with respect to the midpoint, by formula (E14) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;

calculates the position Zm of the magnet in the Z-axis direction with respect to the midpoint, by formula (E15) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;
a denominator DIV2 in the formula (E13), the formula (E14), and the formula (E15) is expressed by formula (E16);

in a case that the product of the Y component Ty1 of the first magnetic flux density and the Y component Ty2 of the second magnetic flux density is greater than or equal to zero, and the magnitude of the first magnetic flux density is less than the magnitude of the second magnetic flux density, the calculation circuit:

calculates the position Xm of the magnet in the X-axis direction with respect to the midpoint, by formula (E17) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;
calculates the position C of the magnet in the Y-axis direction with respect to the midpoint, by formula (E18) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P;
calculates the position Zm of the magnet in the Z-axis direction with respect to the midpoint, by formula (E19) using the X component Tx1 of the first magnetic flux density, the Y component Ty1 of the first magnetic flux density, the Z component Tz1 of the first magnetic flux density, the X component Tx2 of the second magnetic flux density, the Y component Ty2 of the second magnetic flux density, the Z component Tz2 of the second magnetic flux density, and the predetermined distance P; and
a denominator DIV3 in the formula (E17), the formula (E18), and the formula (E19) is expressed by formula (E20):

$$Xm = P \times \frac{\frac{Ty1}{|Ty1|} \times \frac{Tx1}{\sqrt{Ty1^2 + Tz1^2}} + \sqrt{\left(\frac{Tx1}{\sqrt{Ty1^2 + Tz1^2}}\right)^2 + 1}}{DIV2} + \frac{P}{2} \qquad \dots (E13)$$

$$C = P \times \frac{1}{DIV2} \times \frac{Ty1}{\sqrt{Ty1^2 + Tz1^2}} \qquad \dots (E14)$$

$$Zm = P \times \frac{1}{DIV2} \times \frac{Tz1}{\sqrt{Ty1^2 + Tz1^2}} \qquad \dots (E15)$$

$$DIV2 = \frac{Ty2}{|Ty2|} \times \frac{Tx2}{\sqrt{Ty2^2 + Tz2^2}} + \sqrt{\left(\frac{Tx2}{\sqrt{Ty2^2 + Tz2^2}}\right)^2 + 1} - \left(\frac{Ty1}{|Ty1|} \times \frac{Tx1}{\sqrt{Ty1^2 + Tz1^2}} + \sqrt{\left(\frac{Tx1}{\sqrt{Ty1^2 + Tz1^2}}\right)^2 + 1}\right) \qquad \dots (E16)$$

$$Xm = P \times \frac{\frac{Ty1}{|Ty1|} \times \frac{Tx1}{\sqrt{Ty1^2 + Tz1^2}} - \sqrt{\left(\frac{Tx1}{\sqrt{Ty1^2 + Tz1^2}}\right)^2 + 1}}{DIV3} + \frac{P}{2} \qquad \dots (E17)$$

$$C = P \times \frac{1}{DIV3} \times \frac{Ty1}{\sqrt{Ty1^2 + Tz1^2}} \qquad \dots (E18)$$

$$Zm = P \times \frac{1}{DIV3} \times \frac{Tz1}{\sqrt{Ty1^2+Tz1^2}} \qquad \dots(\text{E}19)$$

$$DIV3 = \frac{Ty2}{|Ty2|} \times \frac{Tx2}{\sqrt{Ty2^2+Tz2^2}} - \sqrt{\left(\frac{Tx2}{\sqrt{Ty2^2+Tz2^2}}\right)^2 + 1} - \left(\frac{Ty1}{|Ty1|} \times \frac{Tx1}{\sqrt{Ty1^2+Tz1^2}} - \sqrt{\left(\frac{Tx1}{\sqrt{Ty1^2+Tz1^2}}\right)^2 + 1}\right) \qquad \dots(\text{E}20).$$

**11.** The position calculation device according to claim 9, wherein:

in a case that the product of the Y component Ty1 of the first magnetic flux density and the Y component Ty2 of the second magnetic flux density is greater than or equal to zero, and a magnitude of the first magnetic flux density is greater than a magnitude of the second magnetic flux density, the calculation circuit calculates the position Xm of the magnet in the X-axis direction with respect to the midpoint, by formula (E21) using the X component Tx1 of the first magnetic flux density, the Y component Ty1 of the first magnetic flux density in the Y-axis direction, the Z component Tz1 of the first magnetic flux density in the Z-axis direction, the position C of the magnet in the Y-axis direction with respect to the midpoint as calculated by the formula (E10), and the position Zm of the magnet in the Z-axis direction with respect to the midpoint as calculated by the formula (E11); and

in a case that the product of the Y component Ty1 of the first magnetic flux density and the Y component Ty2 of the second magnetic flux density is greater than or equal to zero, and the magnitude of the first magnetic flux density is less than the magnitude of the second magnetic flux density, the calculation circuit calculates the position Xm of the magnet in the X-axis direction with respect to the midpoint, by formula (E22) using the X component Tx2 of the second magnetic flux density, the Y component Ty2 of the second magnetic flux density, the Z component Tz2 of the second magnetic flux density, the position C of the magnet in the Y-axis direction with respect to the midpoint as calculated by the formula (E10), and the position Zm of the magnet in the Z-axis direction with respect to the midpoint as calculated by the formula (E11):

$$Xm = \sqrt{C^2 + Zm^2} \times \left(\frac{Ty1}{|Ty1|} \times \frac{Tx1}{\sqrt{Ty1^2+Tz1^2}} + \sqrt{\left(\frac{Tx1}{\sqrt{Ty1^2+Tz1^2}}\right)^2 + 1}\right) + \frac{P}{2} \qquad \dots(\text{E}21)$$

$$Xm = \sqrt{C^2 + Zm^2} \times \left(\frac{Ty2}{|Ty2|} \times \frac{Tx2}{\sqrt{Ty2^2+Tz2^2}} - \sqrt{\left(\frac{Tx2}{\sqrt{Ty2^2+Tz2^2}}\right)^2 + 1}\right) - \frac{P}{2} \qquad \dots(\text{E}22).$$

**12.** The position calculation device according to claim 3, wherein when a plurality of magnetic sensors installed on the fixed member are arranged at intervals of the predetermined distance in the first direction, among the plurality of magnetic sensors, one of two magnetic sensors that are adjacent to each other is the first magnetic sensor, and another of the two magnetic sensors is the second magnetic sensor.

**13.** The position calculation device according to claim 3, wherein, in an XYZ coordinate space formed by an X-axis direction, which is the first direction, a Y-axis direction which is perpendicular to the X-axis direction, and a Z-axis direction which is perpendicular to both the X-axis direction and the Y-axis direction, in a case that a direction in which the two magnetic poles of the magnet are arranged alongside one another is in a state of being rotated by an angle α about a W-axis, taking as a reference a U-axis direction in which a U-axis extends, the U-axis being one of the X-axis, the Y-axis, and the Z-axis of the XYZ coordinate space, the W-axis being a coordinate axis other than the U-axis, from among the X-axis, the Y-axis, and the Z-axis, the calculation circuit calculates the position of the magnet, using a U component Tua and a V component Tva obtained by transforming, using formula (E23), a U component Tu of the magnetic flux density in the U-axis direction and a V component Tv of the magnetic flux density in a V-axis direction in which a V-axis extends, wherein the V-axis is a coordinate axis other than the U-axis and the W-axis, from among the X-axis, the Y-axis, and the Z-axis:

$$\begin{pmatrix} Tua \\ Tva \end{pmatrix} = \begin{pmatrix} \cos(-\alpha) & -\sin(-\alpha) \\ \sin(-\alpha) & \cos(-\alpha) \end{pmatrix} \begin{pmatrix} Tu \\ Tv \end{pmatrix} \qquad \dots (\mathrm{E}23).$$

14. The position calculation device according to any one of claims 1 to 13, wherein each of the first magnetic sensor and the second magnetic sensor is a Hall sensor configured to detect the magnetic flux density based on a voltage generated according to a Hall effect.

15. The position calculation device according to any one of claims 1 to 13, further comprising an attachment member (100) configured to be installed in an attachment groove (90) formed in the fixed member.

FIG. 1

# FIG. 2

FIG. 3

FIG. 4

# FIG. 5

FIG. 6

FIG. 7A

FIG. 7B

FIG. 8

FIG. 9

Europäisches
Patentamt
European
Patent Office
Office européen
des brevets

# EUROPEAN SEARCH REPORT

Application Number

EP 23 20 7929

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/081246 A1 (SCHAAF OLIVER [DE]) 19 March 2015 (2015-03-19) | 1-3, 12-15 | INV. G01D5/14 F15B15/28 |
| A | * paragraphs [0005], [0026], [0065], [0066]; figures 1,9 * | 4-11 | |
| X | US 2013/027028 A1 (HOHE HANS-PETER [DE] ET AL) 31 January 2013 (2013-01-31) | 1-3, 12-15 | |
| A | * paragraphs [0007], [0078] * | 4-11 | |
| X,D | EP 3 428 582 A1 (SICK AG [DE]) 16 January 2019 (2019-01-16) | 1-3, 12-15 | |
| A | * paragraphs [0011], [0038], [0051]; figure 1 * | 4-11 | |

TECHNICAL FIELDS
SEARCHED      (IPC)

G01D
F15B

The present search report has been drawn up for all claims

| Place of search | Date of completion of the search | Examiner |
|---|---|---|
| Munich | 4 April 2024 | Bossen, Michael |

EPO FORM 1503 03.82 (P04C01)

## ANNEX TO THE EUROPEAN SEARCH REPORT
## ON EUROPEAN PATENT APPLICATION NO.

EP 23 20 7929

This annex lists the patent family members relating to the patent documents cited in  the above-mentioned European search report.
The members are as contained in the European Patent Office EDP file on
The European Patent Office is in no way liable for these particulars which are merely given for the purpose of information.

04-04-2024

| Patent document cited in search report | | Publication date | Patent family member(s) | | Publication date |
|---|---|---|---|---|---|
| US 2015081246 | A1 | 19-03-2015 | CN | 104220844 A | 17-12-2014 |
| | | | DE | 102012205903 A1 | 17-10-2013 |
| | | | TW | 201407136 A | 16-02-2014 |
| | | | US | 2015081246 A1 | 19-03-2015 |
| | | | WO | 2013153015 A1 | 17-10-2013 |
| US 2013027028 | A1 | 31-01-2013 | CN | 102906542 A | 30-01-2013 |
| | | | DE | 102010003292 A1 | 29-09-2011 |
| | | | EP | 2545342 A1 | 16-01-2013 |
| | | | US | 2013027028 A1 | 31-01-2013 |
| | | | WO | 2011117118 A1 | 29-09-2011 |
| EP 3428582 | A1 | 16-01-2019 | EP | 3428582 A1 | 16-01-2019 |
| | | | JP | 6705867 B2 | 03-06-2020 |
| | | | JP | 2019049528 A | 28-03-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019049528 A